# EUROPEAN PATENT APPLICATION

(11) **EP 2 747 101 A1**
(43) Date of publication of application: **25.06.2014**
(21) Application number: 12008439.7
(22) Date of filing: 19.12.2012
(51) Int. Cl.: H01G 9/20, H01L 51/42, H01L 51/44

(54) **An opto-electronic device and method for manufacturing the same**

(71) Applicant: Swansea University, Swansea SA2 8PP (GB)
(72) Inventor: Wijdekop, Maarten, Wrexham, LL12 9NZ (GB); McGettrick, James Douglas, West Glamorgan, SA2 0DN (GB); Melgari, Paolo, County Durham, DH1 5AE (GB); Hammond, Deborah, 1970 CA Ijmuiden (NL); Ketipearachchi, Udaya S., 1970 CA Ijmuiden (NL); Greenwood, Peter Clarke, Neath-Port Talbot, SA12 6DY (GB); Bryant, Daniel Thomas James, Swansea, SA1 8DE (GB)
(74) Representative: Ratcliffe, Susan Margaret

(57) **Abstract**

The present invention relates to an opto-electronic device (1) comprising:
(a) a first component (2) comprising a transparent electrode (11), and
(b) a second component (3) comprising:
- a metal substrate (5),
- a blocking layer (7),
- an active layer (8), and
- a hole conducting layer (9, 10),
wherein the metal substrate (5) is provided with a plating layer (6).

## Description

The present invention relates to an opto-electronic device such as photovoltaic (PV) devices that converts light into electricity. The present invention further relates to a method for manufacturing such an opto-electronic device.

Dye sensitised solar cells (DSCs) are examples of PV devices that were first developed by Prof Michael Grätzel and co-workers (Nature, 353 (24) 737-740) as alternatives to expensive PV devices based on crystalline silicon. Organic solar cells and solar cells with active materials based on Copper Indium Gallium Selenide (CIGS) and Copper Zinc Tin Sulphide (CZTS) are further examples of PV devices.

DSCs comprise an anodic electrode (working electrode), a cathodic electrode (counter electrode) and an active layer suitable for converting light into electric energy disposed therebetween. At least one of the electrodes should be transparent and both electrodes should be in electrical contact with the active layer.

Attention has recently switched from DSC devices containing a liquid electrolyte solution of iodide/triiodide salts, to solid state dye sensitised solar cell (sDSC) or 'hybrid' devices that use solid hole transporting materials instead. Other emerging hybrid solar cell technologies are perovskite/metal-oxide heterojunction solar cells or mesoscopic solar cells (meso-superstructured solar cells, MSSC's) which are characterised by an extremely thin absorber (ETA) layers. The term 'hybrid solar cells' shall be used to indicate any of the technologies mentioned hereinabove.

Hybrid solar cells typically comprise a blocking layer in the form of a dense metal oxide on the anodic electrode for the purpose of preventing energised electrons in the working electrode recombining with holes in the active layers, which would result in loss of electrical current. Moreover, the presence of a blocking layer in hybrid solar cell devices is known to reduce the occurrence of electrical shorting. Blocking layers may be provided on the working electrode substrate by spray pyrolysis, using a precursor based on a solution of titanium (IV) tetra(isopropoxide). This process, which removes the solvents instantly, is followed by another heating step to remove the other organic compounds in the precursor and to form ('cure') a dense metal oxide coating.

A suitable active layer for hybrid solar cell devices is dye sensitised titania (TiO₂), which is generally provided by applying a paste comprising titania nanoparticles on the blocking layer using a printing or coating process, sintering the applied paste at elevated temperatures above 400°C to form a nanoporous structure of interconnected TiO₂ particles ('sintered titania') and thereafter sensitising the sintered TiO₂ with a light-absorbing dye.

A disadvantage of the above process is that a limitation is placed on the materials that can be used as the working electrode since the working electrode should not thermally degrade when heating or sintering the TiO₂ particles.

A further disadvantage may arise if the working electrode is a metal substrate since such substrates may oxidise at elevated temperatures to form a thin electrically resistive oxide layer on the substrate surface that increases the series resistance and reduces the overall efficiency of the cell.

When titanium foil substrates are used as the working electrode, the oxide layer formed during the sintering process does not result in a prohibitive increase in series resistance. However, titanium foil is expensive and therefore the commercial viability of hybrid solar cell devices comprising titanium electrodes is limited.

A method for manufacturing sDSC devices comprising metallic electrode materials other than titanium foils is known from W02010/107795. According to WO2010/107795, coatings of titanium (Ti) or titanium nitride (TiN) that prevent oxidation are sputtered onto stainless steel before providing a blocking layer and an active layer on the sputtered coating. However, such a method suffers from the disadvantage that the sputtering of Ti or TiN onto a metal substrate such as stainless is not a cost-effective process, since it is slow (< 1 m/min) and the sputter chamber has to be evacuated after every coil, costing time and energy.

It is an object of the present invention to provide a method for manufacturing hybrid solar cell devices that prevents or at least reduces the formation of a resistive oxide layer at the surface of an electrode when the electrode is metallic.

It is another object of the present invention to reduce the occurrence of electrical shorting in hybrid solar cell devices.

It is a further object of the present invention to provide a cost-effective method for manufacturing hybrid solar cell devices.

According to a first aspect of the invention there is provided an opto-electronic device comprising:
(a) a first component comprising a transparent electrode, and
(b) a second component comprising:
   - a metal substrate as a working electrode,
   - a blocking layer,
   - an active layer, and
   - a hole conducting layer, wherein the metal substrate is provided with a plating layer,

It has been found that the overall performance of the opto-electronic device could be improved by providing a working electrode that comprises a plated metal substrate. This improvement has been attributed, at least in part, to the low surface roughness of the plating layer that contributes to reducing the occurrence of electrical shorting in the device. A further advantage is that the plating layer prevents or at least reduces oxidation of the metal substrate when the metal substrate is exposed to elevated temperatures e.g. during the sintering process, by preventing exposure of the metal substrate to oxygen in air. Finally, by using plated metallic substrates as working electrodes, the requirement for more expensive working electrode materials such as titanium foils or vacuum sputtered titanium or titanium alloys (TiN) on stainless steel substrates is avoided. Thus, the overall cost of the opto-electronic device is reduced.

Preferably, the opto-electronic device is an organic light emitting diode (OLED) or a hybrid solar cell selected from a solid state dye sensitised solar cell, (sDSC), a perovskite/metal-oxide heterojunction solar cell, a mesoscopic solar cell or a meso-superstructured solar cell.

The transparent electrode of the first component may comprise a transparent conducting coating stack (hereinafter referred to as 'TCC stack') containing coatings such as indium tin oxide (ITO), silver (Ag) or fluorine-doped tin oxide (FTO) that is applied onto a suitable transparent substrate such as glass or a polyethylene teraphthalate (PET) film. At least 70% of incident light is able to pass through such TCC stack electrodes, meaning a large proportion of light reaches the active layer resulting in good charge carrier generation. Such TCC electrodes typically have a sheet resistance of 15 Ohm/sq or less, preferably between 2 and 8 Ohm/sq.

An advantage of using a transparent electrode based on glass over other substrates such as PET, is that glass is an excellent barrier to water and therefore a subsequent step of having to encapsulate the hybrid solar cell is avoided.

Preferably, the transparent electrode comprises a metal or metal alloy current collector that is embedded in a transparent substrate such as PET. Preferably, the current collector has a pre-determined structure that allows light to reach the active layer. Although a fine grid structure is preferred, striped, linear, square, rectangular, hexagonal, honeycomb or triangular structures are also suitable, current collector structures. Such transparent electrodes exhibit a sheet resistance of 1 Ohm/sq or less, preferably 0.5 Ohm/sq or less. Further, such transparent electrodes have a smooth and flat surface, resulting in improved mechanical and electrical contact between the current collector and an adjacent coating layer.

Preferably the current collector is printed onto a transparent substrate such as PET. The printing of metallic inks, preferably silver or copper metallic inks, enables a fast and continuous manufacturing route. Gravure-printing, flexographic printing or screen-printing are preferred means for printing such metallic inks. Once printed, the inks can be cured in a convection oven or by electromagnetic radiation; infrared (IR) or near infrared (NIR) curing is particularly preferred.

The metal substrate is preferably selected from copper, zinc, aluminium or steel, preferably carbon steel. Such substrates are flexible and exhibit very good mechanical properties that enable opto-electronic devices to be manufactured in a roll-to-roll processing route. These substrates, except zinc, which has a melting point of 419°C, can also withstand high temperature (450-550°C) processes such as curing of the metal oxide blocking layer or sintering of the metal oxide paste. Withstanding in this context means the bulk mechanical properties of the metal substrate are maintained. In the case of zinc substrates or zinc-coated steel substrates, the curing and sintering temperature should be below the melting point of zinc. A preferred curing and/or sintering temperature is between 300 and 400°C.

In the case of carbon steel substrates, these are relatively inexpensive and are particularly suitable for use in building-integrated photovoltaic (BIPV) applications.

The purpose of the blocking layer is to prevent electrons from the working electrode recombining with holes in the hole conducting layer located in the pores of the active layer. The blocking layer preferably comprises a dense metal oxide such as TiO₂. Other suitable blocking layer materials include zinc oxide (ZnO) and tin oxide (SnO₂). Preferably the blocking layer has a layer thickness between 2 and 100 nm.

In a preferred embodiment of the invention the active layer comprises a photoactive material selected from the group consisting of:
(i) an organic semiconductor
(ii) a metal oxide optionally sensitised with a dye or coated with an inorganic absorber
(iii) a semiconductor comprising one or more of copper, indium, gallium, selenium, zinc, tin and sulphur.

Preferably the organic semiconductor (i) comprises a mixture of poly(3-hexylthiophene) (P3HT) and a fullerene derivative such as 6,6-phenyl C61-butyric acid methylester (PCBM). Alternatively, the organic semiconductor may comprise conjugated polymers such as phthalocyanine, polyacetylene, poly(phenylene vinylene) or derivatives thereof.

Preferably the metal oxide (ii) comprises TiO₂, Al₂O₃, ZnO, SnO₂, Nb₂O₅, InO₂, SrTiO₃, NiO or mixtures thereof, with nanoparticulate TiO₂ semiconductor materials being particularly preferred since they afford very good performance. Preferred sensitising dyes comprise organic dyes such as D102, D131 and D149 (Mitsubishi Paper Mills Ltd). Preferred inorganic absorbers include perovskites like CH₃NH₃Pbl₂Cl or CH₃NH₃Pbl₃ Since such materials are very suitable as ETA layers in meso-superstructured solar cells.

The thickness of the sintered metal oxide layer is preferably no greater than 5 µm, preferably between 0.5 and 3 µm.

Preferably the metal oxide is coated with a perovskite inorganic absorber, thereby forming a perovskite/metal-oxide heterojunction.

Preferably semiconductor (iii) comprises Cu(InGa)Se₂ or copper, zinc, tin and sulphide. Such semiconductors shall hereafter be referred to as CIGS and CZTS semiconductors respectively. Very high efficiencies can be obtained when the photoactive material comprises CIGS or CZTS semiconductors, making such semiconductors suitable for use in large area photovoltaic devices.

The hole conducting layer preferably comprises a hole transport material such as 2,2',7,7-tetrakis-(N,N-di-p-methoxyphenyl-amine)9,9'-spirobifluorene (hereinafter referred to as Spiro-OMeTAD). The use of the hole transport material instead of conventional liquid electrolytes has the advantage that issues surrounding the sealing of the liquid electrolyte are avoided. Spiro-OMeTAD is particularly preferred as an organic hole transport material since a good electrical match exists between the energy levels of Spiro-OMeTAD and the material of the active layer. It is preferred to use a Spiro-OMeTAD hole transport material when the material of the active layer comprises a dye sensitised metal oxide such as TiO₂ or a perovskite coated metal oxide.

In a preferred embodiment of the invention the plating layer has an average surface roughness of at most 1 µm. The inventors found that the occurrence of electrical shorting within the device was greatly reduced when the plating layer had an average surface roughness below 1 µm. An average surface roughness between 0.1 and 0.5 µm is particularly preferred since significant reductions in the occurrence of electrical shorting could be obtained.

In a preferred embodiment of the invention the plating layer comprises chromium and chromium oxide, which is naturally formed on the plating layer surface when exposed to air. It has been found that plating layers comprising chromium are particularly effective at reducing the formation of resistive oxides when sintering TiO₂ or other metal oxides. Preferably the working electrode is an electrolytic chrome-coated steel (ECCS). Preferably the thickness of the plating layer comprising chromium and chromium oxide is between 5 and 25 nm.

In a preferred embodiment an intermetallic layer is present between the metal substrate and the plating layer, said intermetallic layer comprising an alloy of a metal from the metal substrate and a metal from the plating layer. When the metal substrate comprises a steel such as carbon steel, it is understood that an intermetallic layer is formed between the steel substrate and the chromium plating layer. This intermetallic layer, comprising iron and chromium, provides additional oxidation protection to the steel substrate during high temperature processes such as sintering.

In a preferred embodiment the plating layer comprises one or more of Mo, Ni or Cu. Such plating layers are very suitable materials for use in a working electrode since they exhibit a low surface roughness that reduces the occurrence of electrical shorting within the device. Further, plating layers comprising one or more of Mo, Ni and Cu are suitable substrates onto which the blocking layer may be applied. When the plating layer comprises one or more of Al, Zn, Mg, Mo, Ni or Cu, the intermetallic layer that is formed when sintering TiO₂ of the blocking layer and/or the metal oxide of the active layer comprises Fe and one or more of Al, Zn, Mg, Mo, Ni or Cu.

In a preferred embodiment of the invention a transparent adhesive is provided between the first component and the second component. The transparent adhesive provides a very good mechanical bond between the first component and the second component.

Preferably the transparent adhesive comprises a synthetic polymer selected from the group consisting at least of epoxy resin, ethylene-vinyl acetate, phenol formaldehyde resin, polyamide, polyacrylates, polyester resin, polyethylene, polypropylene, polysulphides, polyurethane, polyvinyl acetate, polyvinyl alcohol, polyvinyl chloride, polyvinyl chloride emulsion, polyvinylpyrrolidone or silicone; or a natural polymer selected from the group consisting at least of latex, methyl cellulose, mucilage, starch or resorcinol resin. These transparent adhesives are very suitable for providing a mechanical bond between the first component and the second component and exhibit good transparency that enables light to reach the active layer of the second component. Polyacrylates are particularly preferred.

The term 'transparent' generally denotes a material or layer that does not absorb a substantial amount of light in the visible portion of the electromagnetic spectrum. In the context of the present invention, transparent means that at least 50% of the light passes through the material or layer, preferably at least 70%, more preferably at least 90%.

In a preferred embodiment of the invention the transparent adhesive is conductive and preferably comprises a conductive polymer such as poly(3,4-ethylenedioxythiophene):poly(styrenesulfonate) (PEDOT:PSS) and/or a derivative thereof. By providing a transparent conductive adhesive, electrical contact between the active layer and the transparent electrode, i.e. an improvement in conductivity in the z-direction, is obtained.

In a preferred embodiment of the invention the second component comprises a organic conductive layer between the plating layer and the blocking layer, preferably the organic conductive layer is adjacent to the plating layer. The inventors found that the organic conductive layer provides additional oxidation protection during the subsequent steps of heating the blocking layer and sintering the metal oxide of the active layer. Further, the blocking layer can be readily applied onto the organic conductive layer without the need for an additional surface treatment.

Preferably the organic conductive layer comprises a polymeric material such as a polyimide. Polyimides were found to be effective at reducing the extent of oxidation of the metal substrate and the plating layer during subsequent high temperature manufacturing processes such as sintering. Further, polyimides are relatively inexpensive and may be applied using a solution based coating method.

Preferably the organic conductive layer comprises a conductive component such as carbon nanotubes, carbon black, graphite or a combination thereof. Although allotropes of carbon are preferred, any suitable conductive component may be used providing they do not thermally degrade when sintering the blocking layer or the metal oxide paste. Other suitable conductive components include powders of metals or alloys such as Ti or TiN, preferably such metals and alloys are provided in low concentration. Since the opto-electronic device of the present invention has a reverse design, meaning that the light enters the active materials through the counter electrode and not the working electrode, it is not necessary for the conductive component to be transparent or even translucent.

In a preferred embodiment a first transparent conductive layer is provided adjacent to the hole conducting layer. The inventors found that both the lateral conductivity and conductivity in the z-direction of the device could be increased by providing the first transparent layer adjacent to the hole conducting layer.

It is preferred that the first transparent conductive layer comprises a conductive polymer, preferably one or more of:
- poly(3,4-ethylenedioxythiophene):poly(styrenesulfonate) (PEDOT:PSS) and/or derivatives thereof
- polythiophenes and/or derivatives thereof
- polyanilines and/or derivatives thereof
- polypyroles and/or derivatives thereof

A good electrical match exists between the energy levels (work functions) of the above conductive polymers and the hole transport material of the hole conducting layer, such that good electrical conduction, particularly in the z-direction is obtained. Very good conduction in the z-direction is obtained when the first transparent layer comprises PEDOT:PSS and/or derivatives thereof and the hole conducting layer comprises a hole transport material such as Spiro-OMeTAD, due to PEDOT:PSS and Spiro-OMeTAD having similar work functions.

In a preferred embodiment a second transparent conductive layer is provided adjacent to the transparent electrode. It has been found that the lateral conductivity and the conductivity in the z-direction of the device could be improved by providing the second transparent conductive layer.

Preferably the second transparent conductive layer comprises a conductive polymer, preferably one or more of:
- PEDOT:PSS and/or derivatives thereof
- polythiophenes and/or derivatives thereof
- polyanilines and/or derivatives thereof
- polypyroles and/or derivatives thereof

The inventors found that the conduction of electrons in the z-direction was very much improved when the first transparent conductive layer, the transparent conductive adhesive and the second transparent conductive layer comprised the same conductive polymer since this results in a good electrical match between each of the layers. It is particularly preferred that each layer comprises PEDOT:PSS and/or derivatives thereof.

According to a second aspect of the invention there is provided a method for manufacturing an opto-electronic device which comprises the steps of:
(a) providing a first component comprising a transparent electrode;
(b) providing a second component by:
   - providing a metal substrate with a plating layer,
   - providing a blocking layer,
   - providing an active layer,
   - providing a hole conducting layer,
(c) optionally providing a transparent adhesive on the first component and/or on the second component,
(d) providing the first component on the second component to form the opto-electronic device.

In a preferred embodiment the plating layer is provided by electrolytic deposition, which has the advantage that a smooth and flat plating layer is obtained.

In a preferred embodiment the blocking layer is applied using a spray pyrolysis technique. The use of spray pyrolysis to apply the blocking layer has the advantage that a pin hole free or substantially pin hole free layer can be obtained. It was found that a multi-pass spray pyrolysis process is particularly suitable for applying the blocking layer since a further reduction in the number of pin holes in the layer is obtained. Spray pyrolysis is also very suitable for up-scaling and can easily be implemented into a continuous in-line process.

Preferably the blocking layer is prepared from a Ti (IV) isopropoxide solution. The use of infrared radiation to sinter the applied blocking layer is also preferred since this enables a fast process.

The active layer preferably comprises a metal oxide material such as nanoparticulate TiO₂ that is sensitised with a light absorbing dye. Alternatively the active layer comprises a metal oxide such as Al₂O₃, coated with an inorganic perovskite absorber. The active layer may be provided in the form of a paste that is subsequently applied by screen printing or by a doctor blading technique. In order to increase the number of interconnections between TiO₂ particles, the applied paste is preferably heated to a temperature above 400 °C and up to 550°C using infrared radiation. This allows sintering of the metal-oxide particles to take place, resulting in a porous structure of connected particles that provides a large surface area.

In an embodiment the applied TiO₂ paste formulation is sintered at temperatures between 300 and 400°C. This may be achieved by modifying the TiO₂ paste with additives that promote the combustion of the binders in the paste. Preferably, the TiO₂ paste is sintered between 300 and 350°C, which is advantageous since this further reduces the possibility for oxidation to occur at the metal substrate surface. It also enables the use of alternative plating layers such as galvanised, galvannealed or aluminised plating layers that may be applied by hot-dip coating. Such hot-dip coating techniques are less expensive and can be applied faster than plating layers applied by electrolytic deposition. It is more feasible to use lower temperatures during the sintering process of the metal oxide particles, when the thickness of the applied paste is reduced to between 0.1 microns and 2 microns.

The light absorbing dye may be provided by immersing the coated metal substrate comprising sintered TiO₂ in a solution containing one or more light absorbing dyes. Preferred dyes are organic dyes. The dye solution may also contain additives to prevent or at least reduce the dye molecules from aggregating.

An inorganic perovskite absorbing layer may be applied by dispensing a 20% precursor solution in N,N-Dimethylformaldehide onto a mesoporous metal oxide layer followed by spin-coating, or by a slot-die coating or bar coating process.

In a preferred embodiment the hole conducting layer is provided by applying a solution of a hole transport material (HTM) on the active layer. The HTM solution may be prepared by dissolving a HTM material e.g. Spiro-OMeTAD, in a suitable organic solvent such as chlorobenzene, or in an organic solvent mixture. Preferably the HTM solution comprises a metal oxide such as vanadium oxide, molybdenum oxide or cerium oxide for the purpose of oxidising the Spiro-OMeTAD. The HTM solution is preferably provided on the active layer using a doctor blading, roller coating, bar coating, slot die coating or by spin coating technique. This way, the HTM can penetrate the pores of the sintered metal oxide in the active layer and make electrical contact with the dye or the inorganic absorber layer. It is preferred that there is a thin 'over-layer' of HTM on top of the porous metal oxide, which prevents electrical contact between the active layer and the counter electrode.

In a preferred embodiment a first transparent conductive layer is provided adjacent to the hole conducting layer and/or a second transparent conductive layer is provided adjacent to the transparent electrode, preferably by screen printing, gravure printing, bar-coating or doctor-blading.

In a preferred embodiment an organic conductive coating is provided between the plating layer and the blocking layer using a solution based coating method such as roller coating. The use of a solution based coating method has the advantage that the organic conductive layer can be applied as part of a continuous in-line process.

In a preferred embodiment the transparent adhesive is a transparent conductive adhesive prepared by mixing the transparent adhesive with a conductive polymer, preferably PEDOT:PSS and/or a derivative thereof. The transparent conductive adhesive is preferably applied on the first component by bar coating. The wet film thickness of the applied transparent conductive adhesive is preferably between 20 and 100 µm. Once cured, the transparent conductive adhesive preferably has a dry film thickness (DFT) between 5 and 25 microns. It was found that transparent conductive adhesives having a DFT within the aforementioned range exhibited a bulk conductivity between 0.01-30 S/cm, depending on the type of PEDOT:PSS that was used and its concentration in the transparent adhesive.

The invention will be now be elucidated by way of example. These examples are intended to enable those skilled in the art to practice the invention and do not in anyway limit the scope of the invention as defined by the claims.

### EXAMPLES

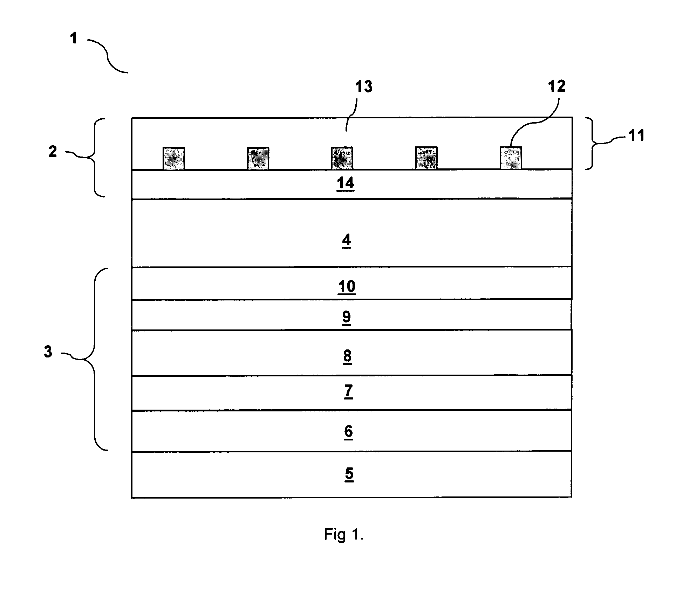

Figure 1 represents an example of a solid state dye sensitised solar cell of the invention. The sDSC comprises a first component (2), a second component (3) and a transparent conductive adhesive disposed therebetween (4). The first component comprises a transparent electrode (11), which comprises a current collector grid (12) embedded in a PET film (13). A PEDOT:PSS transparent conductive layer (14) is provided on the transparent electrode. The second component comprises a carbon steel substrate (5), a plating layer (6), a TiO₂ blocking layer (7), an active layer (8) comprising a porous TiO₂ layer that has been sensitised with a dye, the pores of which have been filled with a Spiro-OMeTAD hole transport material, an over-layer (9) comprising a Spiro-OMeTAD hole transport material, and a PEDOT:PSS transparent conductive layer (10).

A first sDSC (sDSC 1) having an electro-chromium coated steel (ECCS) working electrode was prepared as follows:

An electro-chromium coated steel (ECCS) foil with a 'Fine Stone' surface finish was provided by the TATA Steel Packaging having a thickness of 150 µm, with a chromium coating weight of 50-140 mg/sqm on both sides (of which 7-35 mg/sqm is in chromium oxide). This foil has a surface roughness of 0.25 µm (Ra, measured using stylus profilometry according to ASTM D7127). The ECCS foil was cleaned with acetone and isopropyl alcohol (IPA).

A Ti (IV) isopropoxide solution was then applied on the ECCS foil using multi-pass spray pyrolysis process. During deposition of this TiO₂ layer, the ECCS foil was heated to a temperature above 200°C. Subsequently, the ECCS foil with the applied TiO₂ layer was heated in an IR oven for 2.5 minutes to sinter the applied layer and form a blocking layer that was virtually pin-hole free. The thickness of the blocking layer after sintering was approximately 50 nm.

A TiO₂ containing paste (DSL18NRT, Dyesol) was subsequently screen-printed on the blocking layer and sintered at 500°C for 150 seconds in an Infrared (IR) oven to obtain a nano-porous TiO₂ layer. The dry film thickness of the sintered TiO₂ layer was in the region of 2-3 microns.

The coated ECCS foil comprising the blocking layer and the sintered TiO₂ layer was then immersed in a dye solution containing an organic dye (0.5 mMol of D102 (Mitsubishi Paper Mills Ltd) in a 1:1 mixture of tertiary butanol and acetonitrile). The coated ECCS foil was immersed in the dye solution for 60 minutes at room temperature and then rinsed with acetonitrile to remove any excess dye. The coated ECCS foil was then immersed in isopropyl alcohol (IPA) for 10 minutes and rinsed again with acetone to form the dye sensitised TiO₂ 'active layer'.

A HTM solution containing spiro-OMeTAD (Luminescence Technology Corp.) in chloro-benzene (225mg/ml) was prepared to which was added 47 µl of a LiN(SO₂CF₃)₂ stock solution (170 mg/ml in acetonitrile) and 22 µl of tert-butyl pyridine. 50 µL of this HTM solution was subsequently applied on the active layer. The HTM solution was allowed to penetrate the pores of the dye sensitised TiO₂ active layer for 60 seconds before the excess was removed using a spin coater.

A conductive ink (EL-P-3145, Agfa) containing 0.8% PEDOT:PSS (w/w) was mixed with a suitable organic solvent or solvent mixture and then applied onto the surface of the spiro-OMeTAD hole conducting layer by bar coating. The PEDOT:PSS layer was dried in a hot air flow (65°C) for 7 minutes, using a heat gun. The dry film thickness of the resulting layer was measured at 0.2 µm.

A transparent electrode comprising a transparent polymer (PET) film with an embedded conductive grid (line width 5 µm, pitch 300 µm) was then provided ('Epimesh 300 Gold' from Epigem Ltd).

A conductive ink (EL-P-3145, Agfa) was applied by bar coating on the surface of the transparent electrode. This PEDOT:PSS layer was dried in a hot air flow (65°C) for 7 minutes, using a heat-gun. The dry film thickness of the resulting layer was measured at 0.2 µm.

A transparent conductive adhesive was prepared by mixing an acrylic adhesive (Styccobond F46) with a PEDOT:PSS ink (EL-P-3145, Agfa) in a 1:1 ratio by weight. This mixture was stirred for approximately two minutes and then subjected to a low pressure environment to remove entrapped air. The transparent conductive adhesive was then bar coated on the second transparent conductive layer on the transparent electrode. The applied transparent conductive adhesive had a wet film thickness of 90 microns.

The transparent electrode, coated with the layer of PEDOT:PSS and the transparent conductive adhesive, was then subjected to a 60°C heat treatment in a convection oven for fifteen minutes to remove any low boiling point solvents. The temperature was then increased to 120°C for five minutes to remove the higher boiling solvents in the transparent conductive adhesive. After curing, the transparent conductive adhesive exhibited a bulk conductivity of 0.03 S/cm.

The coated transparent electrode comprising the cured transparent conductive adhesive was manually laminated (at room temperature with 1 bar of mechanical pressure) on the coated ECCS foil such that the transparent conductive adhesive was in contact with the PEDOT:PSS layer of on the transparent electrode and the PEDOT:PSS layer on the coated ECCS substrate.

A second sDSC (sDSC 2) having an ECCS working electrode was prepared in the same way as the first sDSC (1) except that a layer of a conductive polyimide was provided on the ECCS foil before the blocking layer was applied. The conductive polyimide was prepared by adding conductive carbon particles to a polyamic acid resin and then applying the mixture on the ECCS substrate by reverse roller coating. The applied mixture was cured at a temperature of 350 °C to obtain a conductive polyimide layer having a dry film thickness between 5 and 20 µm.

A comparative sDSC (C1) was prepared in accordance with the method for manufacturing sDSC 1 except that the working electrode consists of a 100 µm stainless steel substrate provided with a 30 nm thick sputtered titanium nitride layer (supplied by Sidrabe, Latvia). This sample had a surface roughness of 0.08 µm (Ra measured using stylus profilometry according to ASTM D7127).

A second comparative sDSC (C2) was prepared in accordance with the method for manufacturing sDSC 1 except that the working electrode consists of a 100 µm thick titanium foil with a measured surface roughness of 0.13 µm (Ra measured using stylus profilometry according to ASTM D7127).

To test the performance of the sDSC devices, I-V (current-voltage) measurements were taken using a Dyesol UPTS solar simulator and a Keithley Instruments Model 2400 source meter. This system uses a class C lamp and light filters to simulate sunlight equivalent to the intensity of light being produced at 1 sun (100 mW/cm²).

Each sDSC that was produced was tested in an identical manner, ensuring that every cell was cold and had a clean surface when it was placed in the test chamber. The cells were tested from -0.8 to 1.0 V in order to obtain their short circuit current (J_{sc}) and the open circuit voltage (V_{oc}). The results were plotted as an I-V curve. From the obtained I-V curves, the efficiency and the Fill Factor (FF) can be determined. The results are shown in Table 1.

**Table 1: Performance data of sDSC devices measured at 100mW/cm² irradiation (full sun).**

| Sample Number | Area (cm²) | Ra (µm) | V_{oc} (V) | J_{sc} (mA/cm²) | FF | Efficiency (%) |
|---|---|---|---|---|---|---|
| sDSC 1 | 0.72 | 0.25 | 0.802 | 4.62 | 0.537 | 1.99 |
| sDSC 2 | 0.56 | 0.76 | 0.712 | 4.44 | 0.363 | 1.15 |
| C1 | 0.64 | 0.08 | 0.730 | 6.26 | 0.386 | 1.76 |
| C2 | 0.77 | 0.13 | 0.694 | 4.68 | 0.347 | 1.13 |

The results show that the best performance (1,99%, sDSC1) was obtained when electro-chromium coated steel (ECCS) is used as the working electrode and when a TiO₂ blocking layer is provided adjacent to the ECCS substrate. The Fill Factor of 0.537 indicated that the internal resistance of this cell is low, implying that there is an effective electron transfer process from the active layer to the metal substrate (through the blocking layer and the plating layer). At the same time, the high values for the V_{oc} (0.802 V) and J_{sc} (4.62 mA/cm²) indicate that there is no back-reaction taking place and no electrical shorting. This means that the blocking layer that has been deposited is uniform and free of pin holes. It is thought that the intermetallic region between the steel and the plated chromium layer contributes to the prevention of oxidation of the steel during the high temperature process steps, thereby preventing the formation of resistive oxides that increase the internal resistance of the cell.

SDSC2 shows a credible performance with an efficiency of 1.15%. The difference in efficiency with sDSC1 is mainly due the lower Fill Factor (0.363), which is thought to be caused by resistive losses in the conductive polyimide coating between the ECCS substrate and the blocking layer, or by the contact resistance between the polyamide coating and the ECCS substrate.

However it is thought that the conductive polyimide or variations thereof may enable the use of less stable plated metal substrates as working electrodes, such as the options that have been mentioned in the preceding text. The purpose of the conductive polyimide in this application would be protecting these metal substrates and their plating layers from oxidation during the high temperature process steps.

The comparative sample C1, which used TiN coated stainless steel as the working electrode, has been added here to compare the present invention to the metallic electrode materials proposed by Konarka in W02010/107795. The performance of C1 is not as good as that of sDSC1.

The comparative sample C2, which used Titanium foil as the working electrode, has been added here as a reference. The performance of C2 is not as good as that of sDSC1 or sDSC 2.

It has been shown here that a working electrode based on an inexpensive substrate such as ECCS can at least emulate the performance of more expensive titanium foil substrates, which are normally used for flexible sDSC devices, and that of TiN coated stainless steel.

It has also been shown that for sDSC devices with a sintered TiO₂ active layer of 2-3 microns, using ECCS with a 'Fine Stone' finish (surface roughness 0.25 µm) as a working electrode results in good cells.

Furthermore, a steel substrate coated with a conductive polyamide coating having a surface roughness of 0.76 µm was proven to be suitable as a working electrode substrate, as no shorting was observed in sDSC 2.

## Claims

1. Opto-electronic device comprising:
(a) a first component comprising a transparent electrode, and
(b) a second component comprising:
- a metal substrate,
- a blocking layer,
- an active layer, and
- a hole conducting layer, wherein the metal substrate is provided with a plating layer.

2. Opto-electronic device according to claim 1, wherein the plating layer has an average surface roughness (Ra) of at most 1 µm, preferably between 0.1 and 0.5 µm.

3. Opto-electronic device according to claim 1 or claim 2, wherein the metal substrate comprises copper, zinc, aluminium or steel, preferably carbon steel.

4. Opto-electronic device according to any one of the preceding claims, wherein the plating layer comprises chromium.

5. Opto-electronic device according to any one of the preceding claims, wherein the plating layer comprises one or more of Al, Zn, Mg, Mo, Ni or Cu.

6. Opto-electronic device according to any one of the preceding claims, wherein an intermetallic layer is present between the metal substrate and the plating layer, said intermetallic layer comprising an alloy of a metal from the metal substrate and a metal from the plating layer.

7. Opto-electronic device according to any one of the preceding claims, wherein a transparent adhesive is provided between the first component and the second component, preferably the transparent adhesive comprises a conductive polymer.

8. Opto-electronic device according to any one of the preceding claims, wherein the second component comprises an organic conductive layer between the plating layer and the blocking layer, preferably the organic conductive layer is adjacent to the plating layer.

9. Opto-electronic device according to any one of the preceding claims, wherein a first transparent conductive layer is provided adjacent to the hole conducting layer and/or wherein a second transparent conductive layer is provided adjacent to the transparent electrode.

10. Opto-electronic device according to claim 9, wherein the first and/or second transparent conductive layers comprise a conductive polymer, preferably one or more of:
- poly(3,4-ethylenedioxythiophene):poly(styrenesulfonate) and/or derivatives thereof
- polythiophenes and/or derivatives thereof
- polyanilines and/or derivatives thereof
- polypyroles and/or derivatives thereof

11. Method for manufacturing an opto-electronic device which comprises the steps of:
(a) providing a first component comprising a transparent electrode;
(b) providing a second component by:
- providing a plated metal substrate,
- providing a blocking layer,
- providing an active layer
- providing a hole conducting layer,
(c) optionally providing a transparent adhesive on the first component and/or on the second component,
(d) providing the first component on the second component to form the opto-electronic device.

12. Method according to claim 11 wherein the plating layer is provided by electrolytic deposition.

13. Method according to claim 11 or claim 12, wherein the organic conductive coating is applied using a solution based coating method.

14. Method according to any of the preceding claims wherein the transparent adhesive is a transparent conductive adhesive prepared by mixing the transparent adhesive with a conductive polymer, preferably poly(3,4-ethylenedioxythiophene):poly(styrenesulfonate) and/or a derivative thereof.

15. Method according to any one of claims 11-14, wherein the second component is provided on the first component by laminating.
